# EUROPEAN PATENT SPECIFICATION

(11) **EP 0 406 859 B1**
(45) Date of publication and mention of the grant of the patent: **10.01.1996**
(21) Application number: 90112855.3
(22) Date of filing: 05.07.1990
(51) Int. Cl.: C08K 3/00

(54) **Process for producing a resin molded article having a metal plated layer thereon**
Verfahren zur Herstellung von metallbeschichteten Kunststoffgegenständen
Procédé pour la préparation d'un article de matière plastique ayant un revêtement métallisé

(30) Priority: 07.07.1989 JP 176059/89; 07.09.1989 JP 232404/89; 20.06.1990 JP 161569/90
(43) Date of publication of application: 09.01.1991
(73) Proprietor: MITSUI PETROCHEMICAL INDUSTRIES, LTD., Tokyo 100 (JP)
(72) Inventor: Ikerjiri, Fumitoshi, Mitsui Petrochem. Ind. Ltd., Yamaguchi 740 (JP); Yamamoto, Sanehiro, Mitsui Petrochem. Ind. Ltd., Yamaguchi 740 (JP); Kawamoto, Keiji, Mitsui Petrochem. Ind. Ltd., Yamaguchi 740 (JP)
(74) Representative: Hansen, Bernd, Dr. Dipl.-Chem.

(56) References cited:
- US-A- 4 552 626
- PATENT ABSTRACTS OF JAPAN vol. 8, no. 145 (C-232)(1582) 6 July 1984,& JP-A-59 53536 (MITSUI SEKIYU KAGAKU KOGYO K.K.) 23 March 1984,

## Description

This invention relates to a method for producing a molded article having a metal plated layer.

Resin molded articles having plated layer formed thereon, which have metallized layer on the surfaces thereof by plating methods, are widely used as decorative resin molded articles which are metal substitutes, or as circuit members which electrically connects circuits or apparatuses through a metallized layer formed on the surfaces thereof in addition to electromagnetic wave shielding members and printed circuit boards (hereinafter, these articles are sometimes generally called as resin molded articles having plated layer formed thereon).

Thermosetting resins such as phenolic resins and epoxy resins, polyimides or polyamides have been used as resins for forming said resin molded articles having plated layer formed thereon.

For example, resin molded articles having plated layer formed thereon by forming plated layer on resin molded articles composed of polyamides have been used as metal substitutes for electrical and electronic components or automotive parts, because polyamides are relatively excellent in mechanical characteristics and heat resistance.

Printed circuit boards produced by forming partially plated layer on the surfaces of molded articles of resins such as polysulfone, polyethersulfone and polyetherimide are known (see, Japanese Laid Open Patent Publication No. 239694/1986 and Japanese Patent Publication Nos. 36290/1979 and 31915/1981).

However, when thermosetting resins are used, it is necessary that uncured thermosetting resins are processed into a desired shape and then cured to produce resin molded articles. Accordingly, there is a problem that the manufacturing process of the resin molded articles having plated layer formed thereon becomes complicated.

Further, the above-mentioned thermosetting resins and such a resin as polysulfone have such a problem that heat resistance is poor. Accordingly, when printed circuit boards are produced by using these resins, there is a problem that the heat resistance of the resins reaches its limit when soldering temperature is elevated to increase the mounting speed of electronic components on the printed circuit boards.

Polyamides have not always sufficiently high heat resistance, are highly water absorbing and have difficulty in forming plated layer having excellent adhesion. Hence, resin molded articles having plated layer formed thereon produced from polyamides have a problem in that they can not meet requirements for automotive decorative parts and parts for circuit-board such as a printed circuit board, which are used under particularly severe conditions.

Polyimides have a problem in that moldability is poor, though they have excellent heat resistance. Namely, when resin molded articles having metallized layer as described above are produced from polyimides, it is necessary that a polyimide precursor is dissolved in a specific solvent such as pyrrolidone, the resulting solution is cast and a curing reaction is carried out while removing the solvent. Hence, there is a problem that the production of resin molded articles having metallized layer is very complicated.

U.S. Patent 4,552,626 discloses a method for metal plating a surface of an article of a filled polyamide, including a step of treating the surface with a solution of an acid. All the polyamides disclosed in the document are aliphatic polyamides.

The present invention is intended to solve such problems associated with the prior art as mentioned above and an object of the present invention is to provide a method for producing a molded article having a metal plated layer thereon, comprising the steps as outlined in claim 1. Preferred embodiments of the method according to the invention are reflected by dependent claims 2 to 7.

The resin compositions used in the method according to the present invention comprise :
(i) a polyamide composed of (A) a dicarboxylic acid component recurring unit comprising a dicarboxylic acid component unit consisting of 30 to 100 mol% of terephthalic acid component unit and 0 to 40 mol% of an aromatic dicarboxylic acid component unit other than terephthalic acid and/or 0 to 70 mol% of an aliphatic dicarboxylic acid component unit having an alkylene group of 4 to 20 carbon atoms and
(B) a diamine component recurring unit comprising an alkylene diamine component unit having an alkylene group of 4 to 25 carbon atoms, said polyamide having a melting point of at least 280°C and a glass transition temperature in the amorphous of at least 70°C;
(ii) 5 to 100 parts by weight, per 100 parts by weight of said polyamide, of at least one inorganic granular filler selected from the group consisting of carbonate, oxide and silicate of alkaline earth metal; and
(iii) 5 to 200 parts by weight, per 100 parts by weight of said polyamide, of at least one inorganic fibrous filler selected from glass fiber, metallic fiber and ceramic fiber;
etching a surface of said resin molded article wherein said etching is carried out by using an oxidizing solution selected from ammonium fluoride/nitric acid, hydrogen fluoride/nitric acid, chromic acid/sulfuric acid and chromic acid/nitric acid solutions and/or sandblasting; electroless plating the etched surface of the article; and electrolytic plating the electroless plated surface of the article.

Since the resin compositions for forming plated layer contain the polyamide composed of the specific recurring units as mentioned above, the compositions have very excellent heat resistance. Further, since the polyamide contained in the resin compositions of the present invention is thermoplastic, resin molded articles can be produced therefrom by injection molding or extrusion molding.

Resin molded articles having plated layer formed thereon, electromagnetic wave shielding materials, decorative resin molded articles and circuit-boards such as printed circuit boards according to the present invention are produced by forming plated layer on the surfaces of molded articles produced from said resin compositions for forming plated layer.

The printed circuit boards of the present invention are produced by forming selectively metallized layers or wiring circuit portions of the surfaces of the molded articles formed from the above-mentioned resin compositions for forming plated layer.

The resin molded articles having plated layer formed thereon according to the present invention are excellent in heat resistance and can be easily produced, because the above-mentioned resin compositions are used.

The method for plating according to the present invention comprising a step of etching surface of a resin molded article formed from said resin composition by using acidic solution of chromic acid, a step of electroless plating the etched surface of the article and electrolytic plating the electroless plated surface of the article.

According to the method for plating of the invention, a plated layer having excellent adhesion properties to surface of the articles can be formed.

The resin compositions for forming plated layer and the resin molded articles having plated layer formed thereon and the method according to the present invention are illustrated in more detail below.

The resin composition for forming plated layer according to the present invention contain a polyamide composed of an aromatic dicarboxylic acid component recurring unit [A] and at least one inorganic filler.

The aromatic dicarboxylic acid component recurring unit [A] constituting the polyamide used in the present invention contains preferably a terephthalic acid component unit (a). The recurring unit containing such terephthalic acid component unit (a) may be represented by the following formula [II-a].

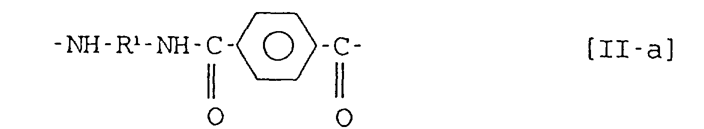

In the above formula [II-a], R¹ represents an alkylene group of 4 to 25 carbon atoms.

The aromatic dicarboxylic acid component unit constituting the polyamide used in the present invention may contain other dicarboxylic acid component units in addition to the above-mentioned terephthalic acid component unit (a).

Aromatic carboxylic acid component units (b) other than the terephthalic acid component unit (a) include component units derived from isophthalic acid, 2-methylterephthalic acid and naphthalenedicarboxylic acid. When the polyamide of the invention contains an aromatic dicarboxylic acid component unit other than terephthalic acid, an isophthalic acid component unit is particularly preferred.

The recurring unit having the isophthalic acid component unit, which is particularly preferred of the aromatic dicarboxylic acid component units other than terephthalic acid component unit may be represented by the following formula [II-b].

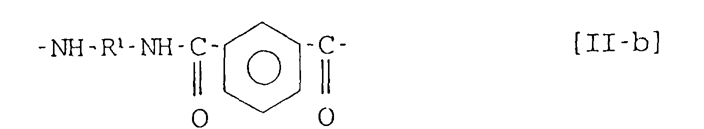

In the above formula [II-b], R₁ represents an alkylene group of 4 to 25 carbon atoms.

The polyamide used in the present invention may contain aliphatic dicarboxylic acid component unit (c) in addition to the aromatic dicarboxylic acid component unit (a).

The aliphatic dicarboxylic acid component unit constituting the polyamide is derived from an aliphatic dicarboxylic acid having an alkylene group of 4 to 20 carbon atoms, preferably of 6 to 12 carbon atoms. Examples of aliphatic dicarboxylic acid used for deriving the component unit (c) include succinic acid, adipic acid, azelaic acid and sebacic acid. When the polyamide of the invention contains such aliphatic dicarboxylic acid component unit, such component unit is preferably an adipic acid component unit in particular.

The recurring unit containing such aliphatic dicarboxylic acid component unit (c) may be represented by the following formula [III].

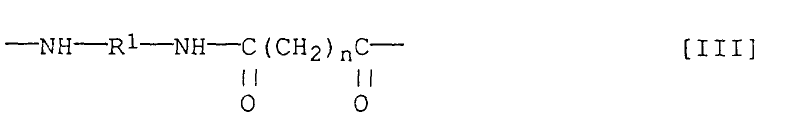

In the above formula [III], R¹ is as defined in the formula [II-a], and n represents an integer of 4 to 20, preferably 6 to 12.

The polyamide used in the present invention preferably contains said dicarboxylic acid component unit [A] and diamine component unit (d) containing alkylene groups of 4 to 20 carbon atoms, and/or cycloalkylenediamine component unit (e) [B].

Said diamine component unit (d) may be derived from aliphatic alkylenediamins of 6 to 18 carbon atoms.

Examples of alkylenediamines for use in deriving such aliphatic alkylenediamine component unit (d) include 1,4-diaminobutane, 1, 6-diaminohexane, trimethyl-1, 6-diaminohexane, 1,7-diaminoheptane, 1,8-diaminooctane, 1,9-diaminononane, 1,10-diaminodecane, 1,11-diaminoundecane and 1,12-diaminododecane.

Component units derived from straight-chain aliphatic alkylenediamines are particularly preferred as the diamine component unit (d) in the present invention. Preferred examples of such straight-chain aliphatic alkylenediamines include 1,4-diaminobutane, 1, 6-diaminohexane, 1,8-diaminooctane, 1,10-diaminodecane, 1,12-diaminododecane and a mixture thereof. Of these diamines, 1,6-diaminohexane is particularly preferred.

Furthermore, the cycloalkylenediamine component unit (e) contained in the polyamide used in the invention is preferably derived from diamine of about 6 to 25 carbon atoms having at least one cyclic aliphatic alkylene.

The alkylene diamine component unit (e) includes component units derived from
1,3-diaminocyclohexane,
1,4-diaminocyclohexane,
1,3-bis(aminomethyl) cyclohexane,
1,4-bis(aminomethyl)cyclohexane,
isophoronediamine,
piperadine,
2,5-dimethylepiperadine,
bis(4-aminocyclohexyl)methane,
bis (4-aminocyclohexyl) propane,
4,4'-diamino-3,3'-dimethyldicyclohexylpropane,
4,4'-diamino-3,3'-dimethyldicyclohexylmethane,
4,4'-diamino-3,3'-dimethyl-5,5'-dimethyl-dicyclohexylmethane,
4,4'-diamino-3,3'-dimethyl-5,5'-dimethyl-dicyclohexylpropane,
α- α'-bis (4-aminocyclohexyl) -p-diisopropylebenzene,
α-α'-bis (4-aminocyclohexyl) -m-diisopropylebenzene,
*α-* α'-bis (4-aminocyclohexyl) -1, 4-cyclohexane,
*α-*α'-bis (4-aminocyclohexyl)-1,3-cyclohexane.

Of these cycloalkylenediamine component unit (e),
bis(aminomethyl)cyclohexane,
bis (4-aminocyclohexyl) methane,
4,4'-diamino-3,3'-dimethyldecyclohexylmethane
are preferably used, and in particular,
bis (4-aminocyclohexyl) methane,
1,3-bis(aminocyclohexyl)methane,
1,3-bis(aminomethyl)cyclohexane are preferred.

In the polyamide which is preferably used in the present invention, the dicarboxylic acid component recurring unit [A] is composed of 60 to 100 mol% of the terephthalic acid component unit (a), 0 to 40 mol% of the aromatic dicarboxylic acid component unit (b) other than terephthalic acid and 0 to 40 mol% of the aliphatic dicarboxylic acid component unit (c).

The polyamide used in the invention contains the terephthalic acid component unit (a) and the component unit (b) derived from dihydric aromatic carboxylic acids other than terephthalic acid which are represented by isophthalic acid as the aromatic dicarboxylic acid compornent units [A], and may contain the above-mentioned aliphatic acid component unit (c) and small amounts of a recurring unit component derived from polycarboxylic acids having at least three carboxyl groups such as trimellitic acid and pyromellitic acid in addition. The content in the polyamide used in the invention of the recurring unit containing the component unit derived from the above-mentioned polycarboxylic acid is usually from 0 to 5 mol%.

The above-mentioned polyamide has an intrinsic viscosity [η] as measured at 30°C in conc. sulfuric acid of usually 0.5 to 3.0 dl/g, preferably 0.5 to 2.8 dl/g and more particularly 0.6 to 2.5 dl/g.

The polyamide used in the invention may be a polyamide mixture consisting of a polyamide having the recurring unit represented by the formula [II-a] as the principal recurring unit, a polyamide having the recurring unit represented by the formula [II-b] as the principal recurring unit and a polyamide having the recurring unit represented by the formula [III] as the principal recurring unit.

When the polyamide used in the present invention is a mixture, it is preferred that the mixture is a composition consisting of the polyamide having the principal recurring unit represented by the formula [II-a] and the polyamide having the principal recurring unit represented by the formula [II-b] and/or the polyamide having the principal recurring unit represented by the formula [III]. The content of the polyamide having the principal recurring unit represented by the formula [II-a] is usually at least 30%.

The mixing ratio of the polyamide having the principal recurring unit represented by the formula [II-a] and the mixture of the polyamide having the principal recurring unit represented by the formula [II-b] and the polyamide having the principal recurring unit represented by the formula [III] is usually 0:100 to 40:60, preferably 0:100 to 30:70 by weight.

The above-mentioned polyamide shows a melting point higher than that of conventionally used aliphatic polyamide. That is, the melting point of the polyamide used in the invention is at least 280°C, preferably 290 to 340°C. Further, the above-mentioned polyamide has a glass transition temperature in its amorphous state of at least 70°C.

By using the polyamide having a melting point and a glass transition temperature in the amorphous portions falling within the above-mentioned ranges in the production of resin molded articles, no molten state of the resin used will be brought about even when the molded article is exposed to elevated temperatures. Further, the above-mentioned polyamide is excellent in moldability and hence resin molded articles of any desired shapes can readily be formed therefrom.

Further, the polyamide used in the invention has a glass transition temperature in the amorphous portion of at least 70°C and hence cracks or the like defects scarcely occur even when exposed to elevated temperatures.

Furthermore, the polyamide used in the invention has a specific structure so that the polyamide has a high flexural modulus at high temperatures and also is low in water absorption properties in comparison with those so far in use, though conventional polyamide has a problem with regard to water absorption properties.

The resin compositions for forming plated layer according to the present invention contain usually at least 50% by weight, preferably 60 to 100% by weight of the polyamide. The polyamide may be used alone or in combination with other resins. Other resins which may be used in combination with the polyamide are preferably heat resistant thermoplastic resins.

Examples of such heat resistant thermoplastic resins include polyolefins, PPS (polyphenylene sulfide), PPE (polyphenyl ether), PES (polyether sulfone), PEI (polyether imide) and LCP (liquid crystal polymers). Of these resins, particularly preferred in the present invention is polyphenylene sulfide.

The content of such heat resistant thermoplastic resin in the polyamide is usually less than 50% by weight, preferably 0 to 40% by weight.

The polyamide (or polyamide composition) and the resins which may be used together with the polyamide can be produced by conventional methods.

The inorganic fillers used together with the above-mentioned polyamide in the present invention are fibrous, granular, needle-like, or plate fillers and includes alkaline earth metal carbonate, oxide and silicate, metallic fiber, asbestos, ceramic fiber, titanium dioxide, alminium oxide, mica, talc, barium sulfate, plaster, zirconium oxide, antimony oxide, clay, silica, silica-alumina. alumina, sericite, kaolin, diatomite, magnesium carbonate, feldspar, silica stone, carbon black, glass bead, Shirasu balloon, red oxide, zinc oxide and Syloid.

The alkaline earth metal carbonate includes magnesium carbonate, calcium carbonate and barium carbonate, the alkaline earth metal oxide includes magnesium oxide, calcium oxide and barium oxide, and the alkaline earth metal silicate includes calcium silicate and magnesium silicate.

Of these fillers, talc and/or the alkaline earth metal oxide, carbonate and silicate are preferably used, and in particular carbonate of alkaline earth metal or oxide of alkaline earth metal such as calcium carbonate or magnesium oxide are preferred. These inorganic filler may be used either alone or as a mixture of two or more of them.

The granular fillers used in the present invention have desirably an average particle diameter of usually 0.1 to 200 µm, preferably 1 to 100 µm. Such granular fillers are used in an amount, based on 100 parts by weight of the polyamide, of usually not more than 100 parts by weight, preferably not more than 50 parts by weight, more preferably 5 to 40 parts by weight. Molded articles formed from the aromatic polyamide containing such alkaline earth metal carbonates are found to have excellent adhesion between the resin and plated layer.

The preferred fibrous inorganic fillers used are glass fibers, potassium titanate fibers and boron fibers. Particularly preferred in the present invention is glass fiber. By using glass fibers, molded articles formed from the resin compositions are improved in mechanical characteristics such as tensile strength, bending strength, flexural modulus, etc. and in heat resistant characteristics such as heat distortion temperature.

The glass fibers as mentioned above have an average length of usually 0.1 to 20 mm, preferably 0.3 to 6 mm and an aspect ratio of usually 10 to 2000, preferably 30 to 600. By using the glass fibers having an average length and an aspect ratio falling within the above-mentioned ranges, the polyamide compositions are improved in moldability and molded articles having plated layer thereon formed from the polyamide compositions containing the glass fibers are improved in heat resistant characteristics such as heat distortion temperature and in mechanical characteristics such as tensile strength, flexural strength, etc.

The glass fibers are used in an amount, based on 100 parts by weight of the polyamide, of usually not more than 200 parts by weight, preferably 5 to 180 parts by weight, more preferably 5 to 150 parts by weight.

In the present invention, the resin compositions for forming plated layer may be incorporated, besides the above-mentioned granular inorganic fillers and fibrous inorganic fillers, with organic or other inorganic fillers, antioxidants, ultraviolet light absorbers, light stabilizer, heat-resisting stabilizers, phosphite stabilizers, peroxide decomposing agents, basic auxiliary agents, nucleating agents, plasticizers, lubricants, antistatic agents, flame retarders, dyes, etc. The fillers may be in the form of powder, granule, sheet, needle, cloth or mat. Examples of such fillers include powdered, sheet-form, fibrous or cloth-form fabricated articles of wholly aromatic polyamides such as poly-p-phenylene terephthalamide, poly-m-phenylene terephthalamide, poly-p-phenylene isophthalamide, poly-m-phenylene isophthalamide and condensates of diaminodiphenyl ether with terephthalic acid (isophthalic acid) or p-(m-) aminobenzoic acid, wholly aromatic polyamide-imides such as condensates of diaminodiphenyl ether with trimellitic anhydride or pyromellitic anhydride, wholly aromatic polyesters, wholly aromatic polyimides, heterocyclic ring-containing compounds such as polybenzimidazole and polyimidazophenanthroline, polytetrafluoroethylene, etc.

These fillers may be used either alone or as a mixture of two or more of them. These fillers may be treated with silane coupling agents or titanium coupling agents.

The powdered fillers have an average particle diameter of usually 0.1 to 200 µm, preferably 1 to 100 µm.

The powdered fillers are used in an amount, based on 100 parts by weight of the polyamide, of usually not more than 200 parts by weight, preferably not more than 100 parts by weight, more preferably 0.5 to 50 parts by weight.

The above-mentioned polyamide (or polyamide composition) may contain electrically conductive materials to shield effectively electromagnetic wave.

Examples of such electrically conductive materials include metals such as iron, aluminum, copper and stainless steel and nickel-coated graphite. Such electrically conductive materials may be in the form of fiber, bundled fiber or powder to incorporate them into resins.

The above-mentioned inorganic filler optionally together with the organic filler can be blended with the polyamide by kneading the components constituting the polyamide composition with the fillers and optionally other resins while each of the components of the polyamide composition is kept in the molten state. Conventional kneading apparatuses such as extruders and kneaders can be used.

The thus-obtained composition may be molded into an article having a desired shape by such molding technique as compression molding, injection molding, extrusion molding or the like.

The resin molded articles having plated layer formed thereon, the electromagnetic wave shielding materials, the decorative resin molded articles and the circuit-boards such as the printed circuit boards according to the present invention have metallized layers (plated layers) formed on the surfaces of the resin molded articles, which are formed in the manner mentioned above by plating methods.

In the resin molded articles having plated layer formed thereon, electromagnetic wave shielding materials, decorative resin molded articles and circuit-boards such as printed circuit boards of the present invention, plated layers may be formed at any positions on the surfaces of the resin molded articles, but in the printed circuit boards, plated layers are selectively formed on wiring circuit portions.

These resin molded articles having plated layer formed thereon according to the present invention may be processed into any form such as film, sheet or box without particular limitation with regard to the shape of the resin molded articles.

Now, methods for forming metallized layers on the surfaces of the resin molded articles formed from the resin compositions of the present invention by plating methods will be illustrated below.

Plating of polyamide resins such as nylon 66 with metals are already known.

Namely, when the polyamide resins are plated, the polyamide resins are usually etched with an acid solution such as hydrochloric acid, sulfuric acid or nitric acid and then plated with metals.

For example, there is described in Polyamide Resin Handbook (p. 264, written Osamu Fukumoto, published by Nikkan Kogyo Shinbunsha) that basic process comprises a step for etching (roughening surface) the resins, a chemical plating step and an electroplating step when the resins are plated with metals.

A large difference between the plating of the resins with metals and the plating of metals is in that a step for etching resins prior to conducting plating is provided when the resins are plated. The adhesion of chemically plated film to the resin is affected by the step and hence a choice of etching solutions is a very important factor. Namely, the point of the etching step is that uniform recessed traces are formed on the surface of a substrate (providing projected complexing effect).

For example, when aliphatic nylon containing a dense mineral filler is immersed in a hydrochloric acid type etching solution in the etching of a substrate composed of aliphatic nylon conventionally used, an amorphous layer on the surface of the substrate is dissolved to thereby roughen the surface of the substrate and a part of the filler drops out, thus forming recessed traces on the surface thereof.

In addition to the above-mentioned hydrochloric acid type etching solution, hydrofluoric acid which erodes the filler is used as the etching solution for the aliphatic polyamide. However, there is described that hydrochloric acid is suitable from the viewpoints of cost and performance.

The plating performance of products obtained, for example, by carrying out chemical plating and electroplating after using the above-mentioned etching solution varies depending on the surface profile of the substrate. Hence, the control of molding conditions is important to obtain the substrate of constant quality. The relationship between mold temperature during the molding of nylon and plate adhesion strength is shown in Table 1.

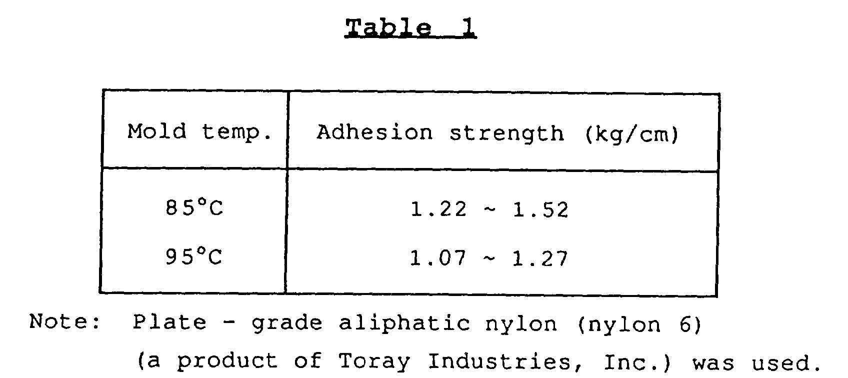

Further, examples of plate adhesion strength and thermal shock resistance of films on plate-grade nylon GF30 (a product of Toray Industries, Inc.) are shown in Table 2.

**Table 2**

| Plate adhesion strength | 1.25 ∼ 1.45 kg/cm |
|---|---|
| Thermal shock resistance | Wheel cap test piece (120°C × 1 hr/-30°C 1 hr) |
| | 100 cycle |
| | Neither swelling nor peeling were observed. |
| | (n = 3) |

Glass fiber-reinforced aliphatic nylon is inferior in plated appearance, but gives plated article having high plate adhesion. Hence, the plated article obtained therefrom is suitable for use as parts for which a high strength is required. Further, there is described that electromagnetic wave shielding properties can be imparted to resin materials by plating them with metals in the manner described above.

Further, Japanese Laid Open Patent Publication No. 155682/1985 discloses a method wherein nylon is etched with a mixed solution of phosphoric acid and sulfuric acid and then plated.

As described above, many methods for plating resins with metals have been conventionally proposed. Certain methods have already been put to practical use.

However, polyamides conventionally subjected to plating are aliphatic nylons such as nylon 66. The plating of aromatic polyamides concerned with the present invention has been scarcely studied so far.

The present inventors have made attempts to plate aromatic polyamides with metals according to conventional methods and found that in many cases there is a difficulty in forming plated layer having sufficient adhesion even when etching treatment with acidic solutions conventionally used is carried out.

Further, the present inventors have made studies to find out an etching solution for forming plated layer having sufficient adhesion on the aromatic polyamide used in the invention and found that acidic chromic acid solutions, more specifically a solution of chromic acid/sulfuric acid and a solution of chromic acid/nitric acid which have not been used as etching solutions for polyamide as yet are most suitable.

Accordingly, it is preferred that acidic chromic acid solutions are used as etching solutions when a metallic thin film is formed on the molded articles formed from the resin compositions of the invention by utilizing plating methods.

Etching treatment with such acidic chromic acid solutions may be carried out in a similar manner to conventional acid treatment. However, when the aromatic polyamide base material to be treated is immersed in an acidic solution (the temperature of the treating solution being 50 to 80°C) containing chromic acid at a concentration of 20 to 50% in particular, the condition of the base material is made very good.

When the resin compositions for forming plated layer according to present invention contain the inorganic filler, the molded articles formed therefrom are immersed in an acidic solution which is a good solvent for the polyamide and the alkaline earth metal carbonates, etc. and the surfaces of the molded articles are then made hydrophilic and roughened by chemical means such as an etching treatment in an oxidizing solution to thereby enable plated layer to be mechanically, firmly bonded to the surfaces of the molded articles.

Suitable acidic solutions include sulfuric acid, nitric acid hydrochloric acid, phosphoric acid and cresol, sulfuric acid solutions and nitric acid solutions are particularly preferred. Examples of the oxidizing solution used in the etching treatment include solutions of ammonium fluoride/nitric acid and hydrogen fluoride/nitric acid in addition to the solutions of chromic acid/sulfuric acid and chromic acid/nitric acid. Particularly preferred are chromic acid/nitric acid solution.

The etching treatment for roughening the surfaces of the molded articles is not limited to the chemical means as mentioned above, but may be carried by mechanical means such as sandblasting or by the combination of chemical means with mechanical means.

As concrete usages of the molded articles having plated layer formed thereon according to the present invention, the molded articles having chemical plated layers are used for the electromagnetic wave shielding materials as it is or after coating with paint. The molded articles having chemical plated layers are used for the decorative resin molded articles after electro-plating thereon.

A concrete example of chrome plating comprises a step of checmical plating with nickel and copper, and a step of usual electroplating consisting of semigloss nickel plating and bright nickel plating or chrome plating carried out after the semigloss nickel plating. However, the printed circuit boards of the invention have selectively plated layers on wiring circuit portions of the surfaces of the resin molded articles.

The circuit-boards can be produced by the following methods.
(a) A method (two-shot method) wherein the molded article having circuit pattern is formed in two stages with two different molding resin compositions. The adhesion of molded portion formed from the first resin composition to plated layer can be enhanced by adhesion promotion stage, and the first resin composition contains a plating catalyst or catalytically functions in plating by an activation stage. The adhesion of molded portion formed from the second resin composition to plated layer can not be enhanced by adhesion promotion, and the second resin composition neither contain any plating catalyst, nor catalytically functions by activation stage. The plated layer as circuit pattern on the molded article is selectively formed only the surface of the molded portion formed from the first resin composition.
(b) A photosensitizing process (PSP) wherein the molded article is adhesion promoted and treated with a metal salt solution which catalytically functions in plating by chemical or radiation reduction. The metal salt is reduced in the presence of a photomask of the desired circuit pattern to form metallic sites only in the circuit portion, and only the circuit portion is selectively plated.
(c) A method (Additive method) wherein the molded article is adhesion promoted and immersed in an activator solution for electroless plating to deposit a seeder on the surface of the molded article. A plating resist is formed on the portion of the surface other than the desired circuit pattern, and only the circuit portion is selectively plated.
(d) A method wherein the molded article is adhesion promoted and a conductive paste is printed by screen printing on the surface of the molded article to form the circuit portion, and the molded article is immersed in a plating solution to form selectively the plated layer only in the circuit portion.

Of the above-mentioned methods, particularly preferred are the methods (a) or (b) in order to form a three dimensional circuit on the surface of the molded article.

In an embodiment of the plating method, the resin molded article treated as mentioned above is washed with water, and Pd is then deposited on the surface of the base material (catalysting). An aqueous solution of a metal complex salt such as a tin-palladium complex salt (e.g., PdCl₂: 0.1 to 0.4 g/l, SnCl₂-2H₂O: 5 to 30 g/l, 36% HCl: 100 to 300 ml/l) is used for the catalysting. The catalysting using such an aqueous solution is usually carried out by setting the temperature to from 20 to 40°C and the time to from 1 to 5 minutes. After the catalysting is carried out in the manner described above, acceleration is conducted by using an aqueous solution of acid such as hydrogen chloride and sulfuric acid, and chemical plating is then carried out by using an electroless plating solution to form a metal-plated layer such as a copper-plated layer, nickel-plated layer or a nickel/copper-plated layer on the base material. The electroless plating is usually carried out at a temperature of 20 to 40°C over a period of 5 to 30 minutes.

Base materials having metallized layers formed thereon by chemical plating in the manner described above may be used as the molded articles having plated layer formed thereon in the present invention. Electrolytically plated layer can be formed on the electrolessly plated layer. The electrolytically plated layer can be formed by conventional methods.

The metal-plated layer, that is, conductive layer formed in the manner described above has a thickness of usually 0.1 to 2.0 µm, preferably 0.4 to 1.6 µm.

While the method for producing the molded articles having plated layer formed thereon by metal plating method has been illustrated in some detail as an example by the above-mentioned electroless plating method comprising the steps of etching, catalysting, accelerator, electroless plating and electrolytic plating, the molded articles having plated layer formed thereon according to the present invention are not limited to those produced by the above-mentioned method.

Further, in case of plating the resin composition according to the present invention, the moisture absorption of the articles formed from the resin composition must be considerated as in the case where the conventional polyamide resin is coated, adhered or plated etc.

This fact is disclosed by Kimiaki Kanki that it must be so careful that the molded articles to be coated don't absorbe water [(Toshiba), Sikizai 54(7), 451(1981), "problems of coating of plastic moldings"].

The resin compositions for forming plated layer used in the method according to the present invention contain the polyamide comprising the specific recurring units as mentioned above so that the molded articles formed therefrom are low in water absorption properties, have a high adhesion strength to the plated layer and are very excellent in heat resistance. The polyamide contained in the resin compositions is thermoplastic and hence the resin compositions can be molded into various resin molded articles of any desired shapes by such molding technique as injection molding, extrusion molding or the like. The molded articles having plated layer formed thereon can be advantageously used for various purposes.

The resin molded articles having plated layer formed thereon, the electromagnetic wave shielding materials, the decorative resin molded articles and the circuit-boards such as the printed circuit boards have plated layers formed on the surfaces of the molded articles formed from the above-mentioned resin compositions and hence they are excellent in heat resistance, can easily be produced and have the following advantages according to their uses.

The electromagnetic wave shielding materials and connecting materials of the present invention are produced from the molded articles formed from the above-mentioned resin compositions containing the polyamide having excellent heat resistance so that they can sufficiently withstand heat when these materials are incorporated into devices or are used, and further they can withstand working heat as well as soldering heat. Soldering portions scarcely suffer solder cracks caused by linear expansion due to heating.

The decorative resin molded articles produced by the method of the present invention have very good heat resistance. They have plated layers formed by plating method so that they have sheeny surface appearance. The adhesion of the molded articles to the plated layers is high so that they can be advantageously used as metal substitutes for automotive parts which are used under severe conditions.

The method for plating according to the present invention comprising a step of etching surface of a resin molded article formed from said resin composition by using acidic solution of chromic acid, a step of carrying out electroless plating the etched surface of the article and a step of carrying out electroplating the surface of the plated layer.

According to the method for plating of the invention, a plated layer having excellent adhesion properties to surface of the articles can be formed.

The present invention is further illustrated in more detail by the following examples. It should be appreciated that the invention is not restricted to the examples.

### Example 1

### Molding

Using an ordinary twin-screw vented pelletizer (PCM45 manufactured by Ikegai Iron Works Ltd.), pellets were prepared by pouring through a hopper 60 parts by weight of a polyamide resin having the composition mentioned herein below into the pelletizer and pouring further through a side feeder a filler as indicated in Table 3 (glassfiber : chopped strand of 13 µm in diameter and 3 mm in length) and presetting the cylinder temperature at 340°C.

The polyamide used contained 50 mol% of the dicarboxylic acid component unit consisting of 35 mol% of terephthalic acid component unit and 15 mol% of isophthalic acid component unit (the aromatic dicarboxylic acid component unit other than terephthalic acid) and as the diamine component unit 50 mol% of hexamethylenediamine component unit. The polyamide had an intrinsic viscosity [η] (as measured at 30°C in conc. sulfuric acid) of 1.1 dl/g and a glass transition temperature of 125°C.

Using an injection molding machine (IS 55 EPN manufactured by Toshiba Machine Co., Ltd.), the pellets obtained were injection molded at the cylinder temperature of 330°C and the mold temperature of 120°C to prepare a resin molded article of 2 × 120 × 130 mm.

### Plating

The molded article obtained above was subjected to degreasing by wiping with a cloth immersed in isopropylalcohol and immersing for 3 minutes in a cleaning solution containing 50g/l of OPC-250 Cleaner (trade name, manufactued by OKUNO SEIYAKU KK).

The molded article thus degreased was subjected to the surface treatment by immersing it for 10 minutes in an acidic aqueouse solution of chromic acid at 70°C containing 200 ml/l of conc. sulfuric acid, 400 g/l of chromic acid and 0.3g/l of Top Shut (trade name, manufactrured by OKUNO SEIYAKU KK) .

The molded article thus treated was washed at room temperature with aqueous solution containing 5% by weight of 35% HCL, and then immersed for 5 minutes in an aqueous solution at 45°C containing 200 ml/l of B-200 (trade name, manufactured by OKUNO SEIYAKU KK).

Then, the thus-treated article was immersed for 4 minutes in an aqueous solution at 25°C containing tin-palladium complex salt (trade name: A 30 Catalyst, manufactured by OKUNO SEIYAKU KK), hydrogen chloride and water at the volume ratio of 1:1:5.

And then, molded article was subjected to acceleration by immersing it for 4 minutes in an aqueous solution of hydrochloric acid at 50°C containing 10% by weight of 38% HCL.

The molded articles treated above, immersed for 10 minutes in an electroless plating solution at 40°C containing TMP Chemical Nickel A solution, Nickel B solution (trade names, both are manufactured by Okuno Seiyaku Kogyo KK) and water at the volume ratio of 1:1:4 to form a nickel-plated layer of 1 µm. After the electroless plating, the molded article was subjected to electrolytic copper plating. The plated layer thus formed was evaluated by an exterior thereof and adhesion strength.

An adhesion strength of the plated layer of the thus obtained resin molded article is shown by the mean value calculated from the values obtained by measuring the adhesion strength by Instron tester (10mm of peeling width, 30mm/minute of peeling rate and 90° of peeling angle). The results are shown in Table 4.

Between the above-mentioned treatment steps proper water-washing was included.

### Examples 2 to 9

The procedure of Example 1 was repeated except that the inorganic filler indicated in Table 3 were used.

The exterior, the result of the peeling test and the adhesion strength of the plated layers of the resulting resin molded articles having plated layers formed thereon are shown in Table 4.

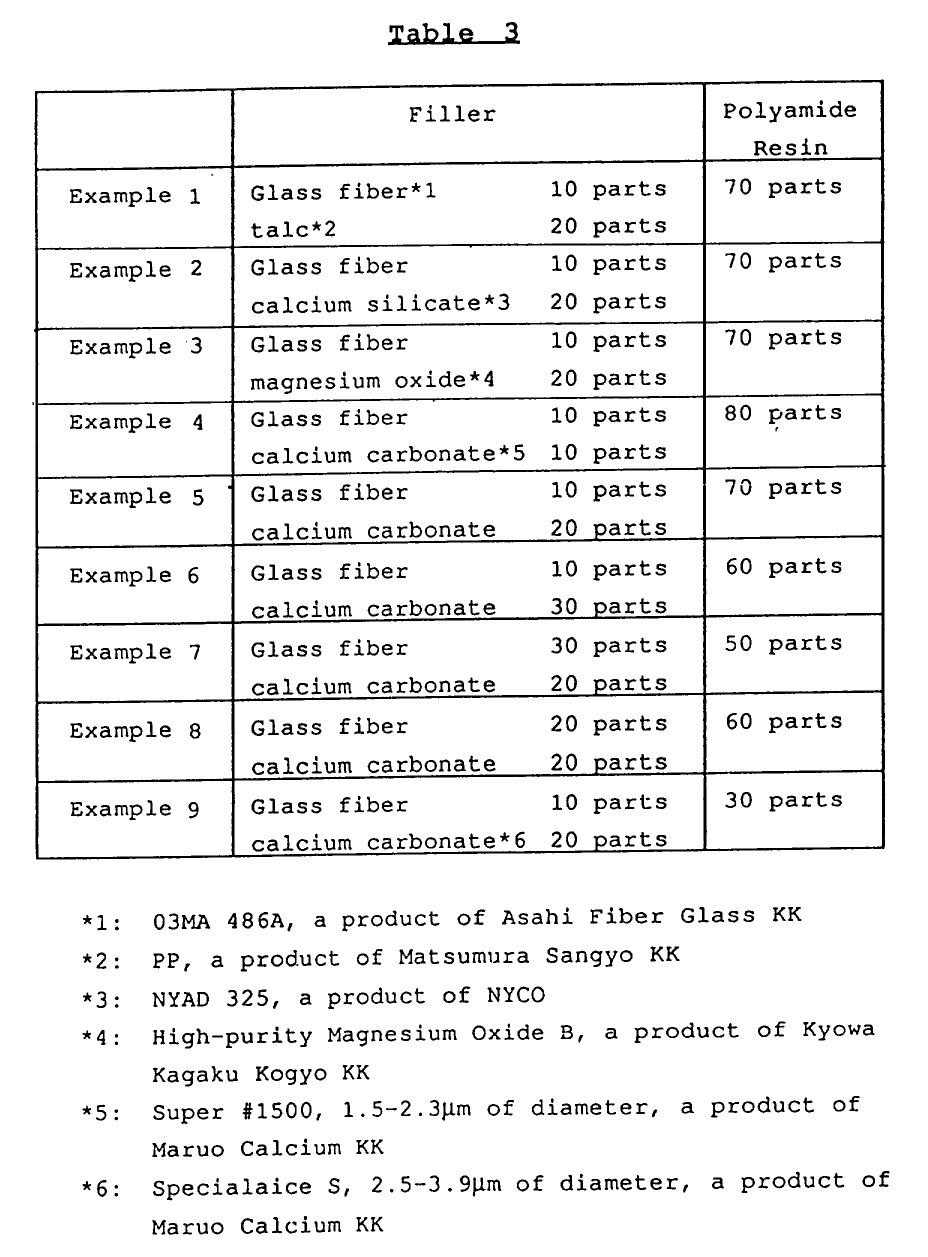

### Referential Example 1

The procedures of Example 1 was repeated except that a conc. hydrochloric acid solution was used in place of the acidic chromic acid solution to form a plated layer. The exterior and the adhesion strength of the plated layers and the result of peeling test are shown in Table 4.

### Referential Example 2

The procedures of Example 1 was repeated except that the inorganic fillers were not used when a molded article was formed and then plating of the molded article was carried out in the same manner as in Example 1.

The exterior and the adhesion strength of the plated layers and the result of peeling test are shown in Table 4.

### Referential Example 3

The procedures of Example 1 were repeated except that 40 parts by weight of glass fiber was used as the sole filler.

The exterior and the adhesion strength of the plated layers and the result of the peeling test are shown in Table 4.

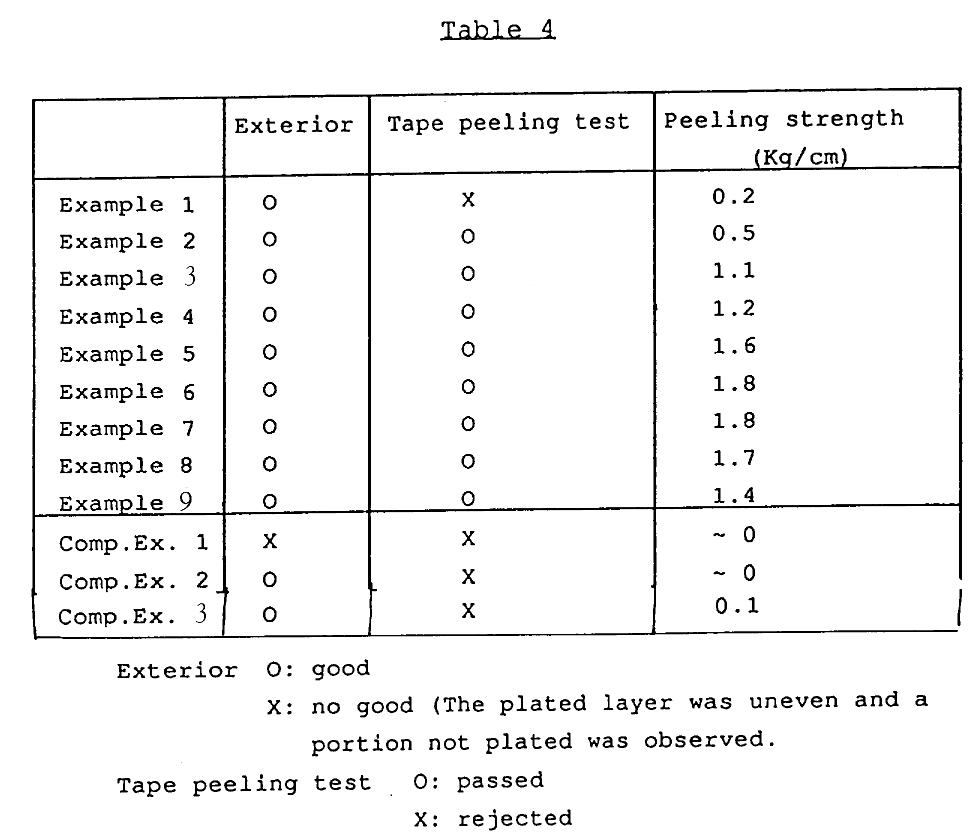

wherein a tape (Trade name Nichiban 405) adhered on the plated layer is pulled at right angle to the layer, A layer which plated metal adhering on the tape was not observed is indicated by O.

A layer which plated metal adhering on the tape was observed is indicated by X.

### Example 10

The procedure of Example 1 was repeated except that a polyamide used contained as an acid component unit 60 mol% of terephthalic acid component unit and 40 mol% of adipic acid component unit, and had an intrinsic viscosity [η] of 1.13 dl/g and a melting point of 326°C (a glass transition temperature thereof was 84°C), and then a molded article obtained therefrom was plated. As a result, the plated layer had a good exterior, passed a tape peeling test and peeling strength thereof was 1.7 Kg/cm.

### Example 11

The procedure of Example 10 was repeated except that a polyamide used contained as an acid component unit 30 mol% of terephthalic acid and 70 mol% of adipic acid component unit, and had an intrinstic viscosity [η] of 1.13 dl/g and a melting point of 281°C (a glass transition temperature thereof was 71°C). As a result, the plated layer had a good exterior passed a tape peeling test and a peeling strength thereof was 1.6 Kg/cm.

### Example 12

The molded article of the Example 5 was used and the procedure of Example 5 was repeated except that an electroless plating aqueous solution containing 10 vol% of Chemical Copper New #100A, 10 vol% of Chemical Copper New #100B and 2.5 vol% of Chemical Copper New #100C (trade names, manufactured by OKUNO SEIYAKU KK) was used to form a copper plated layer of 1 µm, and then, electrolytic copper plating of Example 6 was immediately carried out to form a plated layer of 35 µm. When the molded article having the copper plated layer was immersed for 10 minutes in a solder bath kept at 250 °C, any charges in the exterior thereof were not observed.

### Example 13

The electromagnetic wave shielding characteristics of the molded article having the plated copper layer thereon in Example 5 were examined. The performance thereof was evaluated by transmission line method wherein electromagnetic wave of a measuring frequency of 30, 100, 300 and 1000 MHz was applied thereto. As a result, it was found that the attenuation electromagnetic wave through the plated article had not less than 92 dB at any frequencies. Accordingly, the plated article was very excellent in electromagnetic wave shielding characteristics and in heat resistance.

## Claims

1. A method for producing a molded article having a metal plated layer on a surface thereof comprising:
providing a resin molded article from a resin composition comprising
(i) a polyamide composed of (A) a dicarboxylic acid component recurring unit comprising a dicarboxylic acid component unit consisting of 30 to 100 mol% of terephthalic acid component unit and 0 to 40 mol% of an aromatic dicarboxylic acid component unit other than terephthalic acid and/or 0 to 70 mol% of an aliphatic dicarboxylic acid component unit having an alkylene group of 4 to 20 carbon atoms and
(B) a diamine component recurring unit comprising an alkylene diamine component unit having an alkylene group of 4 to 25 carbon atoms, said polyamide having a melting point of at least 280°C and a glass transition temperature in the amorphous of at least 70°C;
(ii) 5 to 100 parts by weight, per 100 parts by weight of said polyamide, of at least one inorganic granular filler selected from the group consisting of carbonate, oxide and silicate of alkaline earth metal; and
(iii) 5 to 200 parts by weight, per 100 parts by weight of said polyamide, of at least one inorganic fibrous filler selected from glass fiber, metallic fiber and ceramic fiber;
etching a surface of said resin molded article wherein said etching is carried out by using an oxidizing solution selected from ammonium fluoride/nitric acid, hydrogen fluoride/nitric acid, chromic acid/sulfuric acid and chromic acid/nitric acid solutions and/or sandblasting; electroless plating the etched surface of the article; and electrolytic plating the electroless plated surface of the article.

2. The method according to claim 1, wherein said polyamide has an intrinsic viscosity, as measured at 30°C in concentrated sulfuric acid, of 0.5 to 3.0 dl/g.

3. The method according to claim 1, wherein said etching is carried out by using an acidic solution of chromic acid.

4. The method according to any one of claims 1 to 3 for producing an electromagnetic wave shielding material which has a conductive layer on the surface of said resin molded article.

5. The method according to any one of claims 1 to 3 for producing a decorative resin molded article which has a metalized layer on the surface of said resin molded article.

6. The method according to any one of claims 1 to 3 for producing a circuit board which has a selectively metalized layer on the surface of said resin molded article.

7. The method according to claim 6, wherein said circuit board is a printed circuit board.

## Patentansprüche

1. Verfahren zur Herstellung eines Formartikels mit einer galvanisierten Metallschicht auf einer Oberfläche davon, gekennzeichnet durch Bereitstellung eines Harzformkörpers aus einer Harzzusammensetzung, die umfaßt
(i) ein Polyamid, bestehend aus (A) einer Komponente mit sich wiederholenden Dicarbonsäure-Einheiten, bestehend aus einer Dicarbonsäure-Komponenteneinheit, die 30 bis 100 Mol-% einer Terephthalsäure-Komponenteneinheit und 0 bis 40 Mol-% einer aromatischen Dicarbonsäure-Komponenteneinheit, die keine Terephthalsäure ist, und/oder 0 bis 70 Mol-% einer aliphatischen Dicarbonsäure-Komponenteneinheit mit einer Alkylengruppe von 4 bis 20 Kohlenstoffatomen enthält, und
(B) einer sich wiederholenden Einheit einer Diaminkomponente, bestehend aus einer Alkylendiamin-Komponenteneinheit mit einer Alkylengruppe von 4 bis 25 Kohlenstoffatomen, wobei das Polyamid einen Schmelzpunkt von wenigstens 280 °C und eine Glasübergangstemperatur zum amorphen Zustand von wenigsten 70 °C hat;
(ii) 5 bis 100 Gewichtsteile pro 100 Gewichtsteile des Polyamids von wenigstens einem anorganischen Füllstoff, ausgewählt aus der Gruppe, die aus Carbonat, Oxid und Silicat eines Erdalkalimetalles besteht; und (iii) 5 bis 200 Gewichtsteile pro 100 Gewichtsteile des Polyamids von wenigstens einem anorganischen faserförmigen Füllstoff, ausgewählt unter Glasfaser, Metallfaser und Keramikfaser;
Ätzen einer Oberfläche des Harzformartikels, wobei das Ätzen unter Verwendung einer oxidierenden Lösung durchgeführt wird, ausgewählt unter Ammoniumfluorid/Salpetersäure, Fluorwassertoff/Salpetersäure, Chromsäure/Schwefelsäure und Chromsäure/Salpetersäurelösungen und/oder Sandstrahlen; stromloses Galvanisieren der geätzten Oberfläche des Formkörpers; und elektrolytisches Galvanisieren der stromlos galvanisierten Oberfläche des Formkörpers.

2. Verfahren nach Anspruch 1, worin das Polyamid eine Grenzviskosität, gemessen bei 30 °C in konzentrierter Schwefelsäure, von 0,5 bis 3,0 dl/g hat.

3. Verfahren nach Anspruch 1, worin die Ätzung unter Verwendung einer sauren Lösung von Chromsäure durchgeführt wird.

4. Verfahren nach einem der Ansprüche 1 bis 3 zur Herstellung eines Abschirmaterials gegen elektromagnetische Wellen, das eine leitfähige Schicht auf der Oberfläche des Harzformartikels hat.

5. Verfahren nach einem der Ansprüche 1 bis 3 zur Herstellung eines dekorativen Harzformartikels, der eine metallisierte Schicht auf der Oberfläche des Harzformkörpers hat.

6. Verfahren nach einem der Ansprüche 1 bis 3 zur Herstellung einer Leiterplatte, die eine selektiv metallisierte Schicht auf der Oberfläche des Harzformkörpers hat.

7. Verfahren nach Anspruch 6, worin die Leiterplatte eine gedruckte Leiterplatte ist.

## Revendications

1. Procédé pour fabriquer un article moulé ayant une couche revêtue d'un métal sur sa surface, comprenant :
la fourniture d'un article moulé en résine à partir d'une composition de résine comportant :
(i) un polyamide constitué de (A) un motif récurrent d'un constituant acide dicarboxylique comprenant un motif d'un constituant acide dicarboxylique constitué de 30 à 100 moles % d'un motif d'un constituant acide téréphthalique et de 0 à 40 moles % d'un motif d'un constituant acide dicarboxylique aromatique autre qu'un acide téréphthalique et/ou de 0 à 70 moles % d'un motif d'un constituant acide dicarboxylique aliphatique ayant un groupe alkylène de 4 à 20 atomes de carbone et
(B) un motif récurrent d'un constituant diamine comprenant un motif d'un constituant alkylène diamine ayant un groupe alkylène de 4 à 25 atomes de carbone,
ledit polyamide ayant un point de fusion d'au moins 280°C et une température de transition vitreuse à l'état amorphe d'au moins 70°C;
(ii) 5 à 100 parties en poids, pour 100 parties en poids dudit polyamide, d'au moins une charge granulaire minérale choisie dans le groupe constitué d'un carbonate, d'un oxyde et d'un silicate d'un métal alcalino-terreux; et
(iii) 5 à 200 parties en poids, pour 100 parties en poids dudit polyamide, d'au moins une charge fibreuse minérale choisie parmi une fibre de verre, une fibre métallique et une fibre céramique;
l'attaque d'une surface dudit article moulé en résine dans laquelle ladite attaque est effectuée en utilisant une solution oxydante choisie parmi des solutions de fluorure d'ammonium/acide nitrique, acide fluorhydrique/ acide nitrique, acide chromique/acide sulfurique et acide chromique/acide nitrique, et/ou un jet de sable;
le revêtement auto-catalytique de la surface attaquée de l'article; et le revêtement électrolytique de la surface revêtue auto-catalytiquement de l'article.

2. Procédé selon la revendication 1, dans lequel ledit polyamide a une viscosité intrinsèque, mesurée à 30°C dans de l'acide sulfurique concentré, de 0,5 à 3,0 dl/g.

3. Procédé selon la revendication 1, dans lequel ladite attaque est exécutée en utilisant une solution acide d'acide chromique.

4. Procédé selon l'une quelconque des revendications 1 à 3 pour fabriquer un matériau de protection contre les ondes électromagnétiques qui comporte une couche conductrice sur la surface dudit article moulé en résine.

5. Procédé selon l'une quelconque des revendications 1 à 3 pour fabriquer un article moulé en résine décorative qui comporte une couche métallisée sur la surface dudit article moulé en résine.

6. Procédé selon l'une quelconque des revendications 1 à 3 pour fabriquer une plaquette de circuits qui comporte une couche sélectivement métallisée sur la surface dudit article moulé en résine.

7. Procédé selon la revendication 6, dans lequel ladite plaquette à circuits est une plaquette de circuits imprimés.
